(19) Europäisches Patentamt / European Patent Office / Office européen des brevets

(11) EP 1 783 553 A1

(12) EUROPEAN PATENT APPLICATION

(43) Date of publication:
09.05.2007 Bulletin 2007/19

(51) Int Cl.:
*G03F 7/20* (2006.01)

(21) Application number: 05447246.9

(22) Date of filing: 07.11.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(71) Applicant: Interuniversitair Microelektronica
Centrum
3001 Leuven (BE)

(72) Inventor: Gronheid, Roel
3370 Boutersem (BE)

(74) Representative: Bird, William Edward et al
Bird Goen & Co.,
Klein Dalenstraat 42A
3020 Winksele (BE)

(54) **Method of studying interaction between immersion fluid and substrate**

(57) The present invention relates to a method and measurement tools for studying interaction between an immersion fluid (202) and a material (210) in a substrate (212), such as e.g. a photoresist or a topcoat or components thereof. The method comprises providing a spatially controlled contact between only part of the substrate (212) and the immersion fluid (202). The latter can e.g. be performed in a lithographic processing system. A possible way of providing spatially controlled contact is by scanning with the immersion fluid (202) over a region of the substrate (212) comprising the at least first material (210). After the contacting has been performed, analysis results are obtained for at least one of the immersion fluid (202) or the first material (210) in said substrate (212). The latter allows to determine an interaction parameter indicative of said interaction between said immersion fluid (202) and said at least a first material (210) in said substrate (212). Such results may be used for studying the dynamic leaching behaviour and for optimising the corresponding immersion lithographic processing.

Fig. 2

Printed by Jouve, 75001 PARIS (FR)

**Description**

**Technical field of the invention**

The present invention relates to immersion lithographic processing of substrates, e.g. in semiconductor processing. More particularly, the present invention relates to interaction between immersion fluids and substrates during immersion lithographic processing thereof.

**Background of the invention**

In the production of today's integrated circuits, optical lithography is one of the key manufacturing techniques. In order to cope with the ongoing miniaturisation of integrated circuits or other devices and its associated problems, high numerical aperture solutions such as immersion lithographic processing are often applied.

Switching from dry lithography to immersion lithography alters the possible mechanisms for contamination in the optical path of a lithographic system. Using immersion fluid in contact with both the final optical lens of the immersion lithography system and the substrate may lead to changes in the immersion fluid, to changes in the substrate and to contamination of the immersion lithographic system, i.e. of the final lens element in the immersion hood. Changes in the substrate, e.g. the resist or the top coat, typically are caused by penetration of components of the immersion fluid into and leaching of resist components out of the substrate and may result in an altered imaging performance. Changes in the immersion fluid typically are caused by dissolution of components of the substrate, e.g. components of the resist or of a top coat layer on top of the resist, in the immersion fluid, leading to altered optical properties of the immersion fluid. The dissolution of components of the substrate, also referred to as leaching, typically also results in contamination of the final lens element. The lens contamination negatively influences the lens lifetime, which is a function of the degradation rate of contaminated lens material under typical illumination conditions and of the immersion fluid refreshment rate and dynamics in the immersion hood. Typical components that may deteriorate the lens lifetime are photo-acid generators (PAG) and quenchers, present in the resist layer. Therefore, immersion lithography system manufacturers typically provide specific leaching requirements for materials to be used with their system.

Some methods and devices for studying the interaction between the immersion fluid and the substrate have already been developed.

In Advances in Resist Technology and Processing XXII, Proceedings of SPIE 5753 (SPIE, Bellingham, WA, 2005), Conley et al. report on a study of leaching of photo-acid generator from resist material in water. Wafers coated with resist are placed in a 2 inch Petri dish and covered with water for contact times ranging from 30 seconds to 30 minutes. It was concluded that photo-acid generator leaching occurs only upon initial contact with water.

In J. Photopolym. Sci. Technol. 17 (2004) pages 591-594, Dammel et al. describe a method for studying leaching of components from a resist in water. Leaching thereby is studied in an immersion chamber, providing room for a full wafer and an approximately 1 mm thick layer of immersion fluid over the entire wafer and an immersion fluid entrance and exit. After the wafer has been positioned in the immersion chamber, immersion fluid is injected via the immersion fluid entrance thus providing contact with the substrate. The liquid is subsequently removed and analysed, providing information on the leaching behaviour of the components of the resist. A typical liquid filling time or liquid removal time of the immersion chamber is about 3 seconds each, leading to a minimum interaction time of at least about 6 second.

Other techniques and systems still are required to further explore leaching effects between a substrate, e.g. resist layer, and an immersion fluid.

**Summary of the invention**

It is an object of the present invention to provide an improved method and improved measurement tools for studying interaction between an immersion fluid and a substrate as well as to improved lithographic processing. It is an advantage of embodiments of the present invention that the dynamic behaviour of interaction between a substrate and an immersion fluid can be studied, i.e. the behaviour of interaction as a function of time. Moreover, it is an advantage of embodiments of the present invention that interaction between a substrate and an immersion fluid for short interaction time periods can be studied. It is also an advantage of embodiments of the present invention that studying of interaction between a substrate and an immersion fluid can be performed with high controllability. It furthermore is an advantage of embodiments of the present invention that interaction effects between a substrate and an immersion fluid can be studied with high accuracy.

The above objective is accomplished by a method and device according to the present invention.

The present invention relates to a method for determining an interaction parameter indicative of an interaction between an immersion fluid and a material or for studying interaction between an immersion fluid and at least a first material in a substrate suitable for lithographic processing, the method comprising

- providing a spatially controlled contact by providing a relative movement of a contact area between the substrate and the immersion fluid over the substrate;
- thereafter, obtaining analysis results of at least one of said immersion fluid or said at least a first material in said substrate; and,
- determining from said analysis results an interaction parameter indicative of said interaction between said immersion fluid and said at least a first material in said substrate.

It is an advantage of embodiments of the present invention that also interaction in a short interaction time between the immersion fluid and the first area of a substrate suitable for lithographic processing can be studied. With a short interaction time there may be meant interaction times of less than 5 seconds, more preferably of less than 3 seconds even more preferably of less than 2 seconds, still more preferably of less than 1 second. The latter is e.g. advantageous over methods and systems based on pouring water on a substrate and removing it, which results in a lowest controlled time-resolution of about 5 seconds. Embodiments of the present invention may allow the study of the dynamic interaction behaviour between said immersion fluid and said first materials, especially as leaching of e.g. photo-acid generators saturates in short timeframes, e.g. < 5 seconds, and as the contact times between immersion fluid and substrate is short, e.g. less than 1.5 seconds, in a high volume manufacturing lithography system. Said results may stem from a measurement on said immersion fluid or said at least a first material in the substrate after these have been brought in said spatially controlled contact.

Said contact may be a contact between the immersion fluid and only part of the substrate. Only part of the substrate may be only part of one side or surface of the substrate. Said at least a first material may comprise first components, wherein said determining an interaction parameter may comprise determining an interaction parameter indicative of leaching from at least one of said first components of said at least first material in said immersion fluid. Said performing an analysis may be performing an analysis of the presence of a first component in said immersion fluid. It is an advantage of embodiments of the present invention that the dynamic behaviour of leaching from materials suitable for lithographic processing to the immersion fluid can be studied.

Said at least first material may be any of a photoresist or a top anti-reflective coating. The first components of the at least a first material may be a photo-acid generator of said photoresist or components thereof. It also may be a quencher or components thereof. It furthermore also may be a residual casting solvent or components thereof. Said first components may also be components of said top-anti-reflective coating material.

A physical size of said contact area, such as e.g. the physical surface area, may be substantially constant during said providing a spatially controlled contact.

Providing a relative movement of said contact area may comprise providing a contact path by providing a relative movement between said immersion fluid and said first region parallel to said substrate.

The method may comprise, prior to said providing a spatially controlled contact, providing said substrate in an immersion lithography processing system comprising an immersion hood and providing said immersion fluid to said immersion hood, wherein providing a spatially controlled contact is performed using a relative movement between said immersion hood and said substrate. The method may comprise, prior to said obtaining analysis results, collecting said immersion fluid, e.g. from said immersion lithography processing system. It is an advantage of certain embodiments of the present invention that the interaction, i.e. occurring during the providing spatially controlled contact, can be performed in substantially the same conditions as the interaction during lithographic processing of the substrate. It is an advantage of certain embodiments of the present invention that the interaction can be studied under exposure conditions.

Said substrate may furthermore comprise at least a second region, said at least a second region being free from materials comprising said first components, wherein providing a contact path may comprise

- initiating said contact path between said immersion fluid and said substrate in said at least a second region;
- then contacting said immersion fluid with said first region; and
- thereafter, ending said contact path between said immersion fluid and said substrate in said at least a second region.

The interaction time between said immersion fluid and said at least a first material in a first region of a substrate can be selected by selecting any of a speed of relative movement or a contact path length. The interaction time also may be selected by selecting a physical size of said contact area.

Obtaining analysis results of at least one of said immersion fluid or said at least a first material in said substrate may comprise using any of mass spectroscopy, scanning electrochemical microscopy or liquid scintillation counting.

The present invention also relates to a method for setting up lithographic processing of a substrate, the method comprising selecting any of an immersion fluid, a substrate, system parameters of a lithographic processing system or processing parameters of a lithographic process based on dynamic interaction results between an immersion fluid and at least a first material in said substrate as obtained by a method for studying interaction as described above.

The invention furthermore relates to a measurement tool for studying the interaction between an immersion fluid and at least a first material in a substrate suitable for lithographic processing, the measurement tool comprising a means for providing a spatially controlled contact by providing a relative movement of a contact area between the substrate and the immersion fluid over the substrate. The means for providing a spatially controlled contact may comprise a substrate table and a nozzle adapted for providing immersion fluid in contact with a substrate, whereby one of said substrate table or said nozzle may be moveable in an X-direction, Y-direction or an X-Y direction.

The invention also relates to a measurement kit for studying the interaction between an immersion fluid and at least a first material in a substrate suitable for lithographic processing according to a method for studying as described above, the measurement kit comprising said substrate having a first region comprising at least said first material suitable for lithographic processing, the first material comprising first components and having a second region being free of materials comprising said first components.

The invention furthermore relates to a computing means for deriving an interaction parameter for interaction between an immersion fluid and at least a first material in a substrate, the computing means comprising

- a means adapted for obtaining information about a spatially controlled contacting step comprising providing a relative movement of a contact area between the substrate and the immersion fluid over the substrate;
- a means adapted for obtaining information about a quantitative analysis of a component of the immersion fluid in the substrate or of a component of the substrate in the immersion fluid
- a means adapted for deriving from said obtained information a value for an interaction parameter indicative of an interaction between the immersion fluid and the at least a first material in said substrate.

The invention also relates to a computer program product for deriving an interaction parameter for interaction between an immersion fluid and at least a first material in a substrate, the computer program product adapted for

- obtaining information about a spatially controlled contacting step comprising providing a relative movement of a contact area between the substrate and the immersion fluid over the substrate;
- obtaining information about a quantitative analysis of a component of the immersion fluid in the substrate or of a component of the substrate in the immersion fluid; and
- for deriving from said obtained information a value for an interaction parameter indicative of an interaction between the immersion fluid and the at least a first material in said substrate.

The invention also relates to a machine readable data storage device storing the computer program product as described above and to the transmission of the computer program product over a local or wide area telecommunications network.

It is an advantage of embodiments of the present invention that the obtained results on interaction between an immersion fluid and a substrate can be used for providing material specifications.

Particular and preferred aspects of the invention are set out in the accompanying independent and dependent claims. Features from the dependent claims may be combined with features of the independent claims and with features of other dependent claims as appropriate and not merely as explicitly set out in the claims. Although there has been constant improvement, change and evolution of methods for studying leaching, the present concepts are believed to represent substantial new and novel improvements, including departures from prior practices, resulting in the provision of more efficient, stable and reliable methods for studying leaching. The teachings of the present invention permit the design of improved methods and systems for lithographic processing of substrates. The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 is a flow diagram of a method for studying interaction between a substrate and immersion fluid according to the first embodiment of the present invention.
Fig. 2 is a schematic illustration of a set-up as can be used for a dynamic interaction measurement in a method for studying interaction between a substrate and immersion fluid according to embodiments of the present invention.
Fig. 3 is a schematic illustration of an alternative set-up as can be used for a dynamic interaction measurement in a method for studying interaction between a substrate and immersion fluid according to embodiments of the present invention.

Fig. 4a to 4c are schematic illustrations of the relative positions of the immersion fluid, the substrate and the materials to be tested on interaction with the immersion fluid, for different steps in a method for studying interaction according to the second embodiment of the present invention.

Fig. 5 shows a schematic view of simulation results for the soak times of the different areas on a substrate and of the contact path for interaction between materials to be studied and an immersion fluid, as used in a method for studying interaction according to the third embodiment of the present invention.

Fig. 6 illustrates a schematic representation of a measurement tool for studying interaction between a material on a substrate and an immersion fluid, according to the sixth embodiment of the present invention.

Fig. 7 illustrates a schematic representation of a computing means as can be used for studying interaction between a material on a substrate and an immersion fluid, according to the seventh embodiment of the present invention.

Fig. 8 shows experimental results for a study of the interaction between a PAG anion of PAR-817 resist and immersion fluid water as obtained using a method as described in the second embodiment of the present invention.

Fig. 9 shows experimental results for a study of the effect of different solvents used on leaching of a PAG anion of PAR-817, as obtained using a method as described in the second embodiment of the present invention.

Fig. 10a and Fig. 10b shows experimental results for a study of the effect of exposure on leaching of a PAG anion of PAR-817 (Fig. 10a) and of PAR-817 covered with a top coat (Fig. 10b), as obtained using a method as described in the second embodiment of the present invention.

In the different figures, the same reference signs refer to the same or analogous elements.

## Definitions

The following terms are provided solely to aid in the understanding of the invention. These definitions should not be construed to have a scope less than understood by a person of ordinary skill in the art. In embodiments of the present application, the term "substrate" may include not only the basic carrier material but also materials to be processed and typical materials applied for performing a lithographic processing step, such as for example - but not limited to - a bottom anti-reflective coating and/or a resist layer and/or a top coating. The top coating may be a protective coating and/or may be a top anti-reflective coating. The term "substrate" furthermore also may include other materials, such as e.g. other materials used in semiconductor processing. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention. Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein. It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

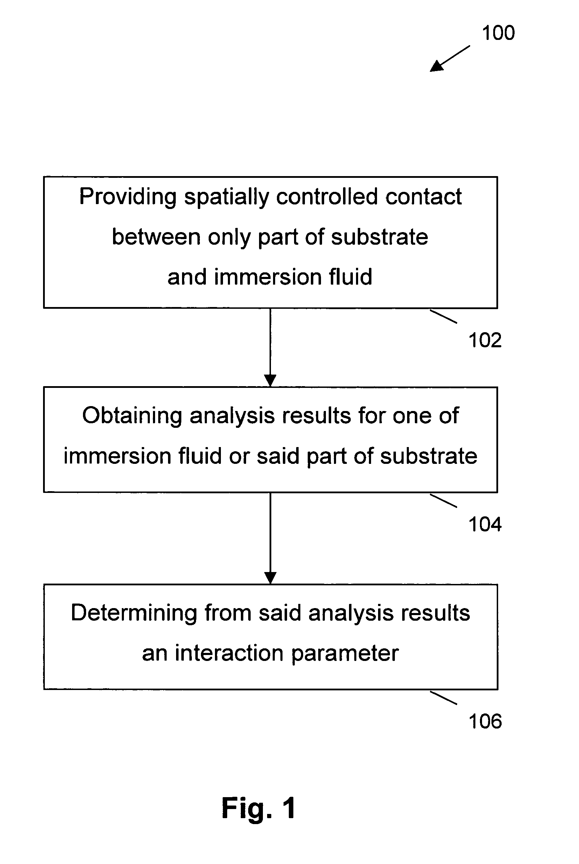

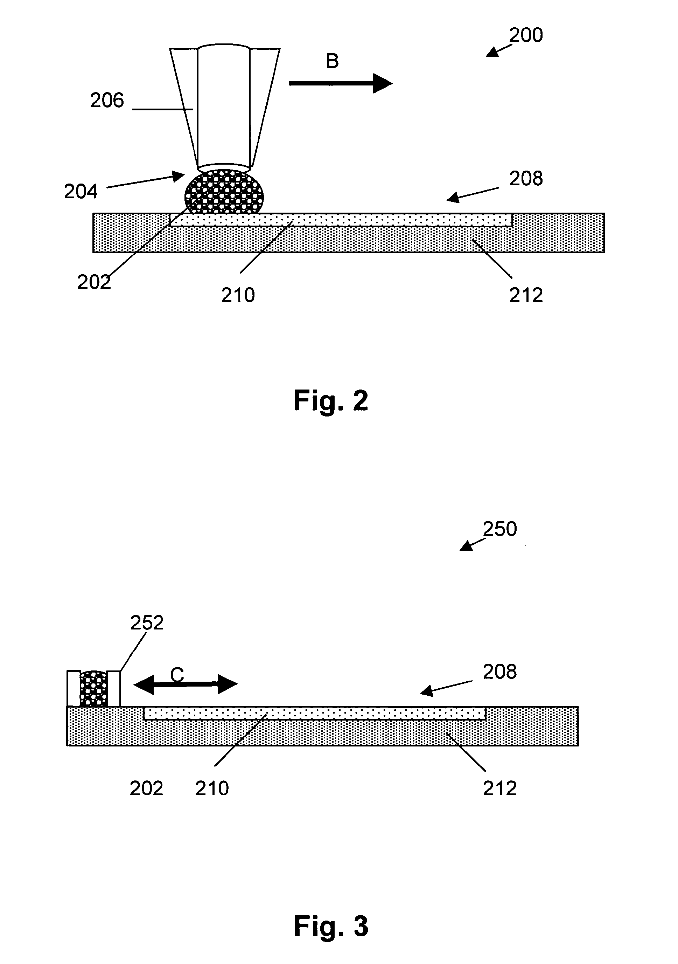

In a first embodiment, the present invention relates to a method for studying interaction between an immersion fluid and materials present in a substrate suitable for lithographic processing, especially in semiconductor processing, e.g. using a semiconductor carrier and layer thereon such as a resist layer. Such materials may be for example - the invention not being limited thereto - material and/or components present in a resist or in a top coating such as a top anti-reflective coating. The present embodiment thus allows study of the interaction of an immersion fluid with materials contacted during immersion lithographic processing of a substrate. Typical steps performed in the method according to the first embodiment of the present invention are shown in a flow diagram of the method for studying interaction 100 in Fig. 1. The method for studying interaction 100 typically comprises providing a spatially controlled contact between the substrate and the immersion fluid by providing a relative movement of a contact area of the substrate and the immersion fluid over the substrate. With contact area, the contact area at the interface at a given time is meant. The spatially controlled contact may be a contact between the immersion fluid and only part of the substrate. The latter is performed in step 102. It may be performed by providing a relative movement between an immersion fluid and a region of the substrate, the region comprising the materials for which interaction is to be studied, i.e. a region where resist or a top coating is applied. Only a part of the substrate may contain material that need to be investigated. Of this part only a limited region may be exposed. The latter could be referred to as a dynamic interaction measurement. The controlled contact is then determined by the rate of movement of the immersion fluid, the surface area of the region of the substrate contacted and the physical dimensions of the immersion fluid at the contact interface. Such movement may e.g. be performed using an immersion lithographic scanning systems, whereby at least one of the immersion hood or the substrate is moveable, in order to allow relative movement. Nevertheless, less complicated set-ups also can be used. Such less complicated set-ups may e.g. comprise a moveable substrate stage, a means for providing and removing immersion fluid in contact with a substrate and a means for providing movement of said contact area between the substrate and the immersion fluid. A schematic illustration of a usable set-up 200 is shown in Fig. 2. An immersion fluid 202 positioned at a tip 204 of a carrier 206, such as e.g. an immersion hood of an immersion lithographic system, and a region 208 of a substrate 212, the region 208 comprising materials 210 for which the interaction properties are to be studied, are moved relatively to each other. Relative movement may e.g. be provided in the direction of arrow B, e.g. in a direction parallel with the surface of substrate 212. As only a limited part of the region may be exposed, the size of the carrier 206 may be less than the dimension of the area under investigation 208. An alternative example of a way of providing controlled contact may be by providing a ring shaped housing, wherein immersion fluid can be provided on the substrate, filling said ring shaped housing with an immersion fluid, shifting said ring shaped housing over the surface of the substrate and removing said fluid from said ring shaped housing. The ring 252 and the substrate 212 are thus moved relative with respect to each other, e.g. as indicated for set-up 250 in Fig. 3 by the direction of arrow C. With spatially controlled contact in step 102 there may be meant that the contact area, e.g. the physical size thereof, is controlled by the user or is automatically controlled. Furthermore, the interaction time may be controlled by the user or may be automatically controlled. Also the interaction interface at each moment of the interaction time span may be controlled by the user or be automatically controlled. Contact may be provided between the immersion fluid and only part of the substrate, meaning only part of one side of the substrate surface. With only part of the substrate there may be meant not the full substrate. Only part of the substrate also may be not the full surface of a single major side of the substrate. The latter thus excludes covering a substrate or an entire surface thereof completely with immersion fluid.

After providing a spatially controlled contact, analysis results are obtained for at least one of the immersion fluid or the area on the substrate comprising the materials for which interaction is to be studied, and which have been contacted with each other. Also part of the immersion fluid or part of the area may be used. This is indicated in step 104. Such analysis may be a qualitative analysis, or more preferably a quantitative analysis, of the presence or concentration of one or more components of the immersion fluid or part thereof in the area on the substrate or of the presence or concentration of one or more predetermined components of the materials present in the area on the substrate in the immersion fluid or part thereof. Such analysis may be performed with any suitable analysis technique. Such analysis techniques preferably are suitable to detect with a detection limit better than a few parts per billion, more preferably with a detection limit better than a few tenths of a part per billion or even better than one tenth of a part per billion and having a detection range up to at least a few hundred parts per billion, preferably up to at least a few parts per million. Typical examples of analysis techniques, the invention not being limited thereto, are mass spectrometry, liquid chromatography-mass spectrometry (LCMS) e.g. with atmospheric pressure electrospray ionisation (AP-ESI), lyofilization, scanning electrochemical microscopy (SECM) and liquid scintillation counting (LSC). Depth profiling of the chemical composition of a substrate may be performed using for example the gradient shaving preparation (GSP) method in combination with analytical techniques such as time of flight-SIMS or fourier-transform infrared spectroscopy (FTIR).. Analysis also may be performed indirectly, e.g. by evaluating lithographic processed structures using the substrate obtained after step 102. In the latter case, structures in the resist obtained after exposure and development of the exposed resist could be studied. Another indirect technique studying the resist development rate using a resist development analyser (RDA). The later allows to study the development rate of resist as a function of exposure. This can in principle be done for areas having a different immersion fluid contact time.

From the obtained analysis results, an interaction parameter can be determined indicative of an interaction between the immersion fluid and materials and/or components on the substrate, e.g. the resist, a topcoat, components of the resist or components of the top coat, as indicated by step 106. The interaction parameter may e.g. a value related to the amount of leached material of a specific component in the immersion fluid per unity of surface contact area, a value related to the amount of an immersion fluid component that has diffused in the materials under study per unity of surface contact area, a value related to the amount of component that has leached or diffused per unity of surface contact area and per unit of interaction time for a given interaction time, etc. For determining these values, typically information about step 102 may be used, e.g. the total surface area of the contact path or contact location, the scan rate or contact time, the physical size and/or the physical shape of the immersion fluid at the interaction interface between the immersion fluid and the substrate possibly at different times of the interaction or throughout the interaction, the applied immersion fluid volume, the distance between the immersion hood and the substrate, etc. The determination of the interaction parameter may be performed using standard methodology or standard procedures. It may e.g. be performed by a computing means, provided with suitable algorithms.

Repeating these experiments for different interaction times may allow obtaining information about the dynamic behaviour of the interaction between the immersion fluid 202 and the components of materials 210 in a region 208 of a substrate 212, i.e. the way the interaction varies with time. It is to be noted that, due to the low concentrations of diffused or leached components it is important to avoid cross-contamination in the experiments. Therefore optional intermediate cleaning steps are preferred. Such cleaning steps may comprise providing additional quantities of immersion fluid with an immersion hood or any other instruments to be used on substrates free of materials to be studied. Furthermore additional efforts may be performed for avoiding cross-contamination by non re-use of recipients, use of fluid dispensers with disposable tips, etc.

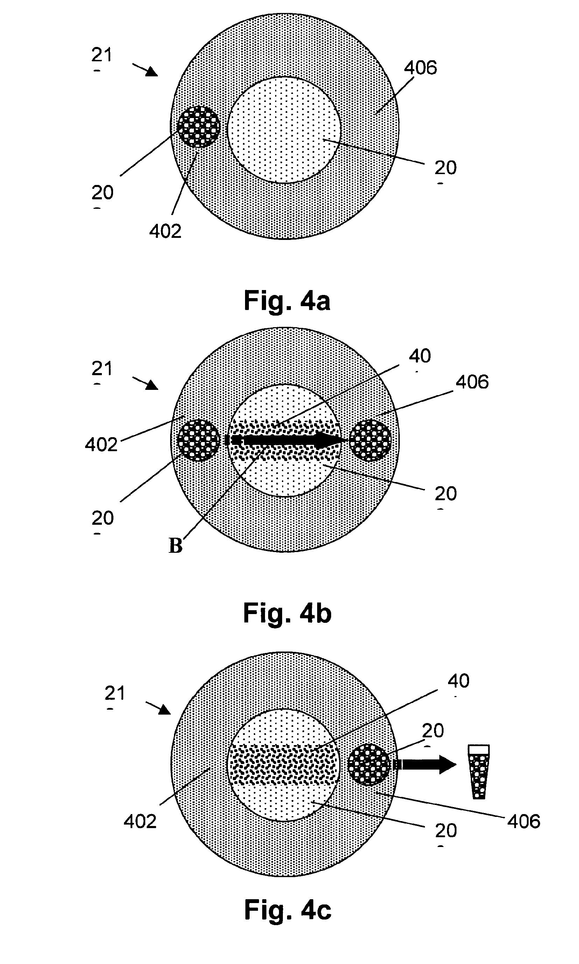

In a second embodiment of the present invention, the present invention relates to a method for studying interaction between an immersion fluid and materials present on a substrate suitable for lithographic processing as described in the first embodiment, but wherein the step of providing a spatially controlled contact between the substrate and the immersion fluid by providing relative movement of the contact area between the substrate and the immersion fluid is obtained by providing a controlled spatial contact path between the substrate 212 and the immersion fluid 202. The controlled spatial contact path may be obtained using a set-up as shown in Fig. 2 or in Fig. 3.. A preferred way of providing a controlled spatial contact path between the substrate 212 and the immersion fluid 202 is shown by the schematic illustrations in Fig. 4a to Fig. 4c. In the method illustrated in Fig. 4a to Fig. 4c, a substrate 212 is used wherein besides a first region 208 comprising materials 210 for which the interaction with the immersion fluid 202 is to be studied, the substrate 212 also comprises a second region 402 free of materials and/or components for which the interaction with the immersion fluid 202 is to be studied. For example, the substrate 212 may be a silicon substrate having, in a first region 208, at least a resist layer or a top coating such as e.g. an anti-reflective top coating, whereas in a second region 402 no resist or top coating is present. The latter may e.g. be obtained by either spatially selective providing the material 210 only in the first region 208 of the substrate 212 or by removing these materials 210 afterwards from the second region 402, e.g. by performing a large edge bead removal. Providing a controlled contact path then may be performed by first contacting the immersion fluid 202 with the substrate 212 in a second region 402, not comprising any component for which the interaction with the immersion fluid 202 is to be studied, as schematically shown in top view in Fig. 4a. During this contacting no leaching of or diffusion into materials for which the interaction is to be studied occurs. The latter may be preferred as the control on the contact time between the immersion fluid 202 and the substrate 212 when applying or removing the immersion fluid 202 may be difficult. Then a relative movement between the immersion fluid 202 and the first region 208 of the substrate 212 comprising the materials and/or components 210 for which the interaction is to be studied, is provided. The latter may be performed by moving either the immersion fluid 202 with respect to the substrate 212 or by moving the substrate 212, e.g. on a substrate stage, with respect to the tip 204 comprising the immersion fluid 202. Typically, for a fixed contact path 404 over the first region 208, the interaction time can be varied by altering the speed of relative movement. If e.g. a fixed speed of movement is used, a well known contact time between the immersion fluid 202 and the materials and/or components 210 in the first region 208 can be determined. During this contact, interaction between the immersion fluid 202 and the materials and/or components 210 in the first region 208 may occur. The latter is schematically illustrated in Fig. 4b, indicating the relative movement by arrow B and indicating the contact path 404. The relative movement between the immersion fluid 202 and the substrate 212 is ended in a third region 406 of the substrate 212, i.e. also a region being free of materials and/or components for which interaction is to be studied. The third region 406 and the second region 402 may be the same region or may be separate and/or different regions. There, no interaction between the immersion fluid 202 and the materials and/or components 210 for which interaction is to be studied occurs anymore. The latter is advantageous as the control on the contact time between the immersion fluid 202 and the substrate 212 when applying or removing the immersion fluid 202 may be difficult. Thus, the path along which interaction may occur thus can be well controlled, i.e. any non-controllability in the removal phase of the immersion fluid does not influence the interaction time. The end phase of the movement is illustrated schematically in Fig. 4c. Such a method may advantageously be performed in an immersion lithography scanner or immersion lithography interference printer allowing movement of either one or both of the substrate or the immersion fluid, via movement of the immersion hood, with respect to each other. The total contact time between the immersion fluid and the materials to be studied typically is a function of contact area, scan speed and length of path followed.

In a third embodiment, the present invention relates to a method for studying interaction between an immersion fluid and a substrate as described in any of the previous embodiments, but wherein, for the step of determining an interaction parameter indicative of said interaction, a physical shape of the immersion fluid 202 at the contact interface between the immersion fluid 202 and the substrate 212 is taken into account. The shape of the immersion fluid 202 at the contact interface between the immersion fluid 202 and the substrate 212 typically is not a square or rectangle but has a droplet shape, such as a substantially round or elliptical shape. When providing a controlled contact using a dynamic interaction measurement as described in the previous embodiments, for a given direction of movement and a given movement rate, different contact times will occur at different positions in the path depending on the shape of the droplet. The shape of the interface during the contact may be fixed and may be taken into account. The latter could e.g. be done based on a model taking into account the lyophilic/lyophobic, i.e. hydrophilic/hydrophobic if the immersion fluid is water, behaviour of the substrate 212, the shape of the means providing relative motion for the contact area, such as e.g. the shape of the tip or ring housing, and the volume of the immersion fluid 202 provided at the tip 204. In other words, in the present embodiment, variation of the contact time at different positions in the contact path 404 is taken into account by determining an average contact time between the immersion fluid 202 and the substrate 212 for the contact. Such an average contact time is determined not only based on the surface area of the contact path 404 on the substrate and a contact time, but also on the momentary shape or different momentary shapes of the immersion fluid 202 at the interface. This leads to a more accurate determination of the interaction parameter.

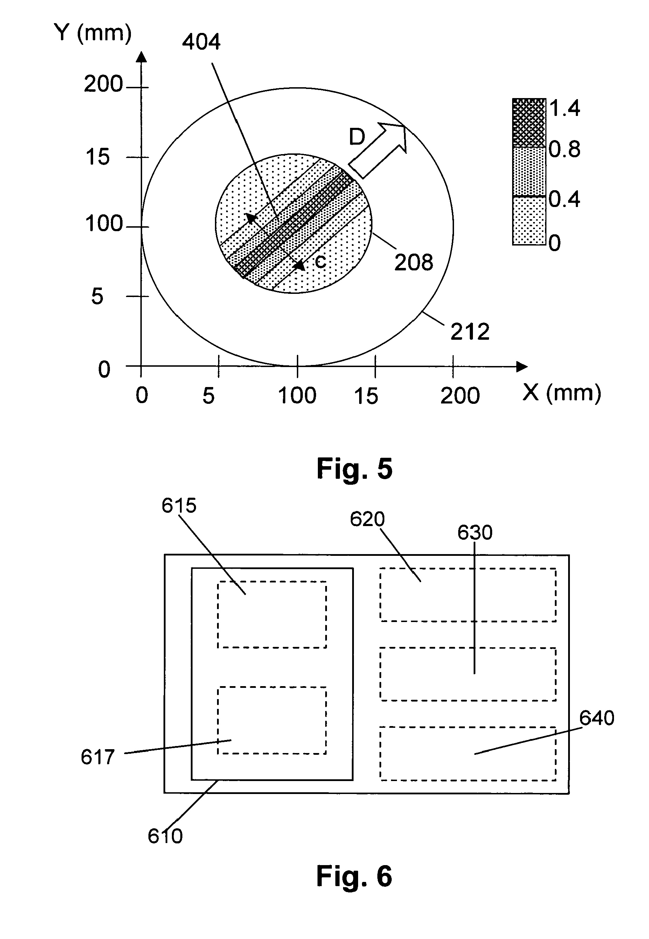

The latter is illustrated for a contact path 404 obtained by relative movement between the immersion fluid 202 and the substrate 212 in a dynamic interaction measurement. Fig. 5 indicates the soak time, i.e. the interaction time between the immersion fluid 202 and the substrate 212 for diagonal scanning at a speed of 24.7mm/second for a rather elliptical interface shape of the immersion fluid 202. It can be seen, in the direction perpendicular to the scanning direction, indicated by arrow D, that the contact time is largest in the centre and smallest at the edges. Taking into account the shape of the immersion fluid 202 at the contact interface and the length of the contact path 404 an average soak time of 0.82 seconds is obtained.

In a fourth embodiment, the present invention relates to a method for setting up a lithographic process. The method comprises selecting a number of system parameters and processing parameters in order to obtain an appropriate lithographic process. It is a specific feature of the present embodiment that at least one of the system parameters and/or at least one of the processing parameters are selected based on interaction properties between the immersion fluid 202 and the substrate 212 determined using a method according to any of the above described methods for studying interaction. The at least one of the system parameters and/or at least one of the processing parameters may comprise for example any of the exposure conditions, the resist used, the presence and/or type of a top coat covering the resist, the type of immersion fluid used, the scan speed of a lithographic scanning system used, etc. As embodiments of the invention allow accurate modeling of the interaction behaviour between the immersion fluid and materials in the substrate, fitting parameters of physical models can be calibrated for any substrate-immersion combination. When exposing a real chip this information can be used to calculate the effective interaction between the immersion fluid and the materials in the substrate, to determine the influence on the dimension control and hence to perform a correction. Such a correction may be a general correction, but also may be a die-by-die correction. As such the information obtained by this method allows obtaining an optimised lithographic process.

In a fifth embodiment, the present invention also relates to a measurement kit for studying the interaction between an immersion fluid and a substrate, e.g. a resist or top coat covering the resist. The measurement kit comprises a tool that typically is adapted for performing a method for studying the interaction by providing a spatially controlled contact between the substrate, or part thereof, and the immersion fluid by providing movement between the contact area between the substrate and the immersion fluid over the substrate. The method for studying the interaction also may comprise obtaining analysis results of at least one of the substrate and the immersion fluid which have been contacted with each other and determining an interaction parameter thereof. Such a tool may be a substrate with a first region comprising at least a first material for which one wants to study the interaction with immersion fluid and a second region being free of such materials or components thereof.

In a sixth embodiment, the present invention relates to a measurement tool for studying the interaction between an immersion fluid and at least a first material in a substrate suitable for lithographic processing, the measurement tool comprising a means for providing a spatially controlled contact by providing a relative movement of a contact area between the substrate and the immersion fluid over the substrate. Such a measurement tool also may comprise a means for providing immersion fluid in contact with the substrate and for removing immersion fluid from the substrate. Such a system may comprise a substrate stage and a means for providing immersion fluid in contact with the substrate. In order to generate relative movement of the contact area between the substrate and the immersion fluid over the substrate, one of the substrate stage or the means for providing immersion fluid is to be moveable. E.g. a setup of at least one, preferably two, scanning stage may be provided, which is able to move, and a fluid head may be provided. Furthermore, an automated or manual fluid dispense and retrieval system may be provided. Also a means for cleaning, such as e.g. a means for providing programmable cleaning cycles, and a robot for substrate manipulation may be provided. A schematic representations of such a set-up is shown in Fig. 6, comprising a means for providing a spatially controlled contact 610 which itself may comprise a substrate stage 615 and a means for providing immersion fluid 617, at least one of these being moveable. Furthermore a means 620 for dispensing and retrieving the immersion fluid also may be provided.

Optionally means for cleaning 630 and means for manipulating substrates 640 also may be provided. The substrate may be part of the tool itself. Furthermore, also more complicated systems, such as for example a system comprising a movable arm having a nozzle for providing a liquid, the moveable arm being adapted for moving over the substrate such that the liquid is in contact with the substrate, may be used.

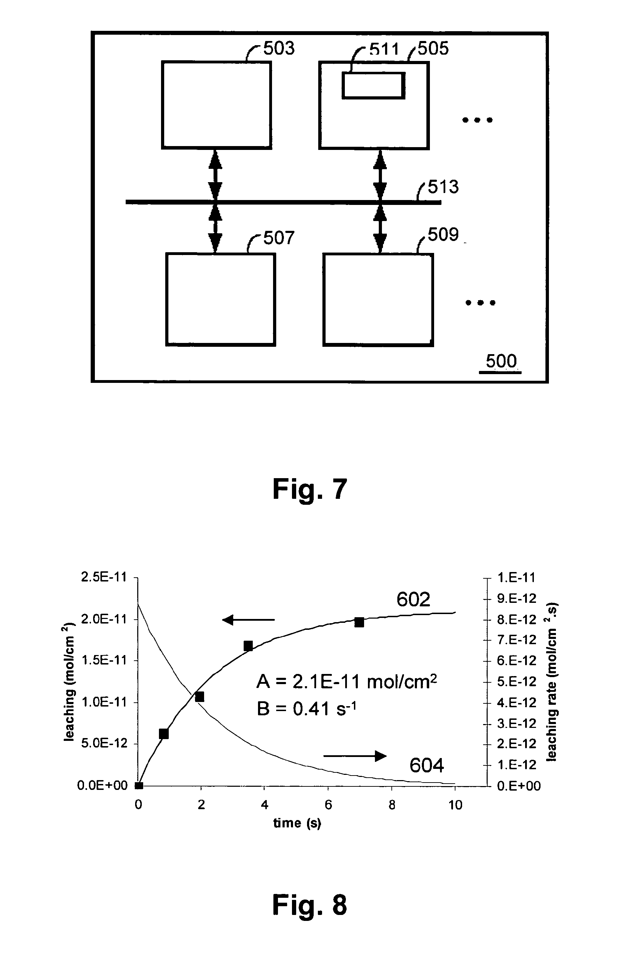

In a seventh embodiment, the present invention also relates to a computing means for deriving an interaction parameter for interaction between an immersion fluid and a substrate suitable for use in lithographic processing. The computing means therefore comprises a means adapted for obtaining information about a spatially controlled contacting step by providing a relative movement of the contact area between an immersion fluid and only part of a substrate and a means adapted for obtaining information about a quantitative analysis of a component of the immersion fluid in the substrate or of a component of the substrate in the immersion fluid. The computing means furthermore comprises a means adapted for deriving from said obtained information about a spatially controlled contacting step and said obtained information about said quantitative analysis, a value for an interaction parameter indicative of an interaction between the immersion fluid and the substrate. In one example, the information about a spatially controlled contacting step by providing a relative movement to the contact area between an immersion fluid and a substrate or part thereof may comprise a movement rate used for moving an immersion fluid over a substrate, size information about a region comprising a material for which interaction with the immersion fluid is to be studied and information about the immersion fluid, such as e.g. a size of the contact interface and a volume of the immersion fluid used. The latter may allow, using the information about the quantitative analysis and using computational power, to derive leaching or dissolution rates and amounts for leaching of components of the substrate in the immersion fluid or dissolution of components of the immersion fluid in the substrate. An exemplary processing system 500 is shown in Fig. 7. Fig. 7 shows one configuration of processing system 500 that includes at least one programmable processor 503 coupled to a memory subsystem 505 that includes at least one form of memory, e.g., RAM, ROM, and so forth. A storage subsystem 507 may be included that has at least one disk drive and/or CD-ROM drive and/or DVD drive. In some implementations, a display system, a keyboard, and a pointing device may be included as part of a user interface subsystem 509 to provide for a user to manually input information. Ports for inputting and outputting data may also be included. More elements such as network connections, interfaces to various devices, and so forth, may be included, but are not illustrated in Fig. 7. The various elements of the processing system 500 may be coupled in various ways, including via a bus subsystem 513 shown in Fig. 7 for simplicity as a single bus, but will be understood to those in the art to include a system of at least one bus. The memory of the memory subsystem 505 may at some time hold part or all (in either case shown as 511) of a set of instructions that, when executed on the processing system 500, implement the step(s) of the method embodiments described herein. Thus, while a processing system 500 such as shown in Fig. 7 is prior art, a system that includes the instructions to implement aspects of the present invention is not prior art, and therefore Fig. 7 is not labelled as

prior art.

It is to be noted that the at least one processor 503 may be a general purpose, or a special purpose processor, and may be for inclusion in a device, e.g. a chip, that has other components that perform other functions. Thus, one or more aspects of the present invention can be implemented in digital electronic circuitry, or in computer hardware, firmware, software, or in combinations of them. Furthermore, aspects of the invention can be implemented in a computer program product tangibly embodied in a carrier medium carrying machine-readable code for execution by a programmable processor. Method steps of aspects of the invention may be performed by a programmable processor executing instructions to perform functions of those aspects of the invention, e.g., by operating on input data and generating output data. Accordingly, the present invention includes a computer program product which provides the functionality of any of the methods according to the present invention when executed on a computing device. Further, the present invention includes a data carrier such as for example a CD-ROM or a diskette which stores the computer product in a machine-readable form and which executes at least one of the methods of the invention when executed on a computing device. Nowadays, such software is often offered on the Internet or a company Intranet for download, hence the present invention includes transmitting the computer product according to the present invention over a local or wide area network.

By way of example, the invention not being limited thereto, experimental results are provided for the study of leaching of photo-acid generator (PAG) from resist. The substrates under test were 200mm silicon wafers prepared using a priming, coating, baking, rinsing and edge cleaning process according to the TEL Act 8 track, as well known by a person skilled in the art. Leaching of the PAG anion of a 150nm PAR817 resist layer, obtainable from Sumitomo Chemical Co, is studied in an immersion interference printer as available from ASML Wilton. A method according to the second embodiment and Fig. 4a to 4c is used. The resist layer is applied to the silicon wafers using in-line dispensing. Quantitative concentration analysis is performed using mass spectrometry with atmospheric pressure electrospray ionisation, leading to a PAG anion detection limit of about 0.2ppb, corresponding with a $3.10^{-14}$ mol/cm$^2$ concentration.

Additional precautions comprising cleaning steps with three water dispensings and retrievals on a non-coated substrate, the use of accurate 1000$\mu$l Finn-pipettes and disposable tips for the pipettes and disposable sample recipients are taken to avoid cross-contamination between experiments. In the bare silicon regions of the resist coated samples, obtained by using an edge bead removal step of 50mm, no detectable leaching is present. These regions are covered with a Hexamethyldisilazane (HMDS) primer, to make the surface hydrophobic, which is required for the immersion interference printer.

Using a scanning method as described in the second embodiment, contact or interaction times between 0.82s and 6.9s are obtained. The latter is within the relevant range for contact times in high volume manufacturing immersion scanners. The shortest contact times thereby are obtained by diagonally scanning using both a horizontal and vertical stage of the immersion interference printer as the latter allows to obtain the highest speed. The total contact time typically is a function of contact area, scan speed and length of path followed. A volume of 2ml of the immersion fluid, being water in the present example, is applied, whereby 1ml immersion fluid is recovered for analysis. For analysis and determination of the interaction parameter, it is assumed that perfect mixing of the immersion fluid and the leached component occurs and furthermore the shape of the immersion fluid at the interface during the contact is taken into account to obtain an average interaction time. The latter is obtained using dedicated software.

For analysis of the effect of exposure on leaching, open frame exposures on an ASML PASS5500/1100 dry 193nm scanner are used followed by the normal leaching procedure.

Results for the dynamic leaching of PAG for an unexposed PAR-817 resist coating are shown in Fig. 8. The amount of leached component per unit of surface contact area, expressed in $mol/cm^2$, is shown as a function of time. The experimental results are indicated using squares. As expected, it can be seen that the amount of leached component per unit of surface contact area saturates within a few seconds. It also can be seen that the amount of leached component per unit of surface interaction at interaction times between 1 and 2 seconds, which are typical interaction times during standard lithographic processing of substrates, differs substantially from this saturation limit. The results are in good agreement with the two parameter model for leaching as described in R.R. Dammel et al. SPIE Proceedings Vol. 7573 (2005) pp95-101. The two parameter model is described by equations [1] and [2]

$$A - A.\exp\left(-Bt\right) \qquad\qquad [1]$$

$$A.B.\exp\left(-B.t\right) \qquad\qquad [2]$$

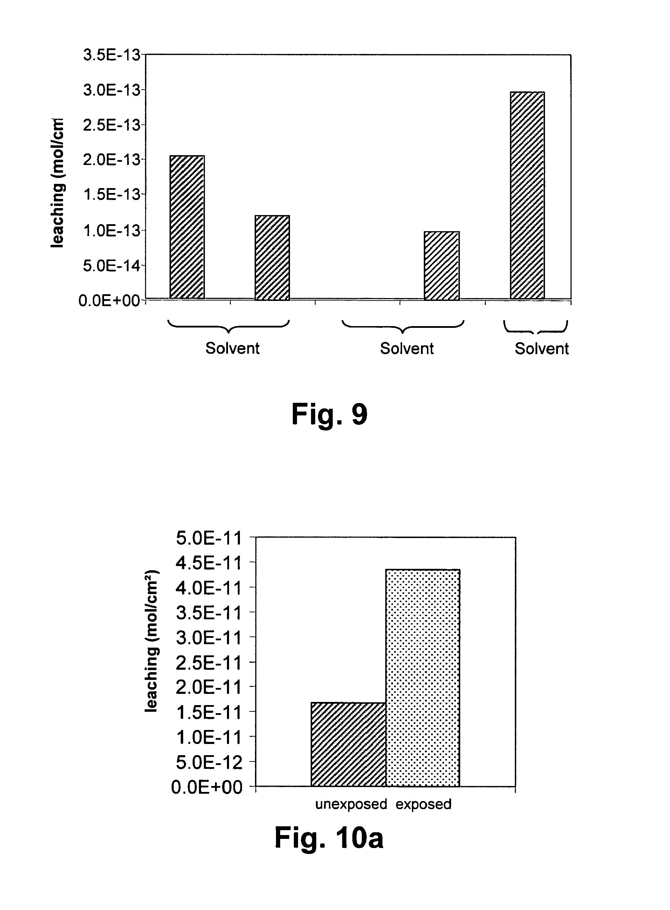

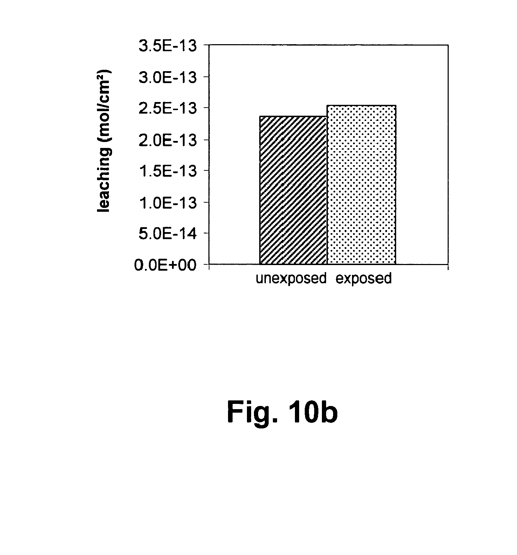

indicating the total amount of leached component in time t and the leaching rate respectively. A (in $mol/cm^2$) thereby gives the saturation level and B (in $s^{-1}$) is a time constant. The larger B, the quicker the saturation level is reached. In Fig. 8, equation [1] is fitted to the experimental results, shown by curve 602. Curve 604 indicates the corresponding leaching rate. From the A and B parameters that have been obtained from the fit, the leaching rate at any point in time can be calculated. The leaching rate at t=0, i.e. the value for A*B, is $8.8*10^{-12}mol/cm^2.s$ and the leached amount in the first second is $7.2*10^{-12}mol/cm^2$. The high leaching levels obtained are not surprisingly, as PAR-817 is developed for dry lithography, not for immersion lithography. In further experiments leaching of a PAG anion in PAR-817 was studied as a function of different parameters of the lithographic processing. Experiments are performed for a PAR-817 resist obtainable from Sumitomo Chemical Co and for a PAR-817 resist covered with a TCX-007 top coat obtainable from JSR Corporation. The amount of leaching as a function of the solvent used is shown in Fig. 9 for different experiments. It can be seen that different solvents may result in different amounts of leaching. Fig. 8 illustrates the effect of another lithographic processing parameter, i.e. exposure, for leaching of a PAG anion in PAR-817 with and without a TCX-007 top coat. It can be seen that a flood exposure has little effect on leaching for a PAR-817 resist with top coat, but that the flood exposure significantly effects leaching in PAR-817 without top coat. The latter is illustrated in Fig. 10a and Fig. 10b showing the leaching effects for resist PAR-817 and for resist PAR-817 with topcoat respectively for both exposed and unexposed substrates with a 25mJ flood exposure.

From the above examples, it can be seen that the leaching measurements can be used for optimising the lithographic processing of a substrate.

It is an advantage of embodiments of the present invention that the amount of immersion fluid used for contacting the substrate may be relatively low, thus increasing to a substantially high component /immersion fluid ratio leading to an increase of the detection limit and an increase in measurement accuracy.

It is to be understood that although preferred embodiments, specific constructions and configurations, as well as materials, have been discussed herein for devices according to the present invention, various changes or modifications in form and detail may be made without departing from the scope and spirit of this invention.

**Claims**

1. A method (100) for studying interaction between an immersion fluid (202) and at least a first material (210) in a substrate (212) suitable for lithographic processing, the method comprising

   - providing (102) a spatially controlled contact by providing a relative movement of a contact area between the substrate (212) and the immersion fluid (202) over the substrate (212);
   - thereafter, obtaining (104) analysis results of at least one of said immersion fluid (202) or said at least a first material (210) in said substrate (212); and,
   - determining (106) from said analysis results an interaction parameter indicative of said interaction between said immersion fluid (202) and said at least a first material (210) in said substrate (212).

2. A method (100) according to claim 1, said at least a first material (210) comprising first components, wherein said determining an interaction parameter comprises determining an interaction parameter indicative of leaching from at least one of said first components of said at least first material (210) in said immersion fluid (202).

3. A method (100) according to any of claims 1 to 2, wherein said at least first material (210) is any of a photoresist or a top anti-reflective coating.

4. A method (100) according to any of claims 1 to 3, wherein a physical size of said contact area is substantially constant during said providing.

5. A method (100) according to any of claims 1 to 4, wherein providing a relative movement of said contact area comprises providing a contact path by providing a relative movement between said immersion fluid (202) and said first region (208) parallel to said substrate (212).

6. A method (100) according to any of claims 1 to 5, the method comprising, prior to said providing a spatially controlled contact, providing said substrate (212) in an immersion lithography processing system comprising an immersion hood and providing said immersion fluid (202) to said immersion hood, wherein providing a spatially controlled contact is performed using a relative movement between said immersion hood and said substrate (212).

7. A method according to any of claims 5 to 6, said substrate (212) furthermore comprising at least a second region (402), said at least a second region (402) being free from materials comprising said first components, wherein providing a contact path comprises

   - initiating said contact path between said immersion fluid (202) and said substrate (212) in said at least a second region;
   - then contacting said immersion fluid (202) with said first region (08); and
   - thereafter, ending said contact path between said immersion fluid (202) and said substrate (212) in said at least a second region.

8. A method according to any of claims 5 to 7, wherein the interaction time between said immersion fluid (202) and said at least a first material (210) in a first region (208) of a substrate can be selected by selecting any of a speed of relative movement or a contact path length.

9. A method according to any of claims 1 to 8, wherein obtaining analysis results of at least one of said immersion fluid (202) or said at least a first material (210) in said substrate comprises using any of mass spectroscopy, scanning electrochemical microscopy or liquid scintillation counting.

10. A method for setting up lithographic processing of a substrate (212), the method comprising selecting any of an immersion fluid (202), a substrate (212), system parameters of a lithographic processing system or processing parameters of a lithographic process based on dynamic interaction results between an immersion fluid and at least a first material (210) in said substrate (212) as obtained by a method according to any of claims 1 to 10.

11. A measurement tool for studying the interaction between an immersion fluid (202) and at least a first material (210) in a substrate (212) suitable for lithographic processing, the measurement tool comprising a means for providing a spatially controlled contact by providing a relative movement of a contact area between the substrate (212) and the immersion fluid (202) over the substrate (212).

12. A measurement kit for studying the interaction between an immersion fluid (202) and at least a first material (210) in a substrate (212) suitable for lithographic processing according to claims 1 to 10, the measurement kit comprising said substrate (212) having a first region (208) comprising at least said first material (210) suitable for lithographic processing, the first material (210) comprising first components and having a second region (402) being free of materials comprising said first components.

13. A computing means for deriving an interaction parameter for interaction between an immersion fluid (202) and at least a first material (210) in a substrate (212), the computing means comprising

- a means adapted for obtaining information about a spatially controlled contacting step between said immersion fluid (202) and only part of said substrate (212)
- a means adapted for obtaining information about a quantitative analysis of a component of the immersion fluid (202) in the substrate (212) or of a component of the substrate (212) in the immersion fluid (202)
- a means adapted for deriving from said obtained information a value for an interaction parameter indicative of an interaction between the immersion fluid (202) and the at least a first material (210) in said substrate (212).

14. A computer program product for deriving an interaction parameter for interaction between an immersion fluid (202) and at least a first material (210) in a substrate (212), the computer program product adapted for

- obtaining information about a spatially controlled contacting step between said immersion fluid (202) and only part of said substrate (212);
- obtaining information about a quantitative analysis of a component of the immersion fluid (202) in the substrate (212) or of a component of the substrate (212) in the immersion fluid (202); and
- for deriving from said obtained information a value for an interaction parameter indicative of an interaction between the immersion fluid (202) and the at least a first material (210) in said substrate (212).

15. A machine readable data storage device storing the computer program product of claim 14.

16. Transmission of the computer program product according to claim 14 over a local or wide area telecommunications network.

100

Providing spatially controlled contact
between only part of substrate
and immersion fluid

102

Obtaining analysis results for one of
immersion fluid or said part of substrate

104

Determining from said analysis results
an interaction parameter

106

Fig. 1

206

204

202

B

200

208

210

212

**Fig. 2**

250

252

C

208

202  210

212

**Fig. 3**

**Fig. 4a**

**Fig. 4b**

**Fig. 4c**

Y (mm)

404

200

15

D

100

C

5

208

0

212

0    5    100    15    200    X (mm)

1.4

0.8

0.4

0

## Fig. 5

615

620

630

617

610

640

## Fig. 6

**Fig. 7**

$A = 2.1E\text{-}11 \ mol/cm^2$

$B = 0.41 \ s^{-1}$

**Fig. 8**

Fig. 9

Fig. 10a

**Fig. 10b**

**European Patent Office**

# EUROPEAN SEARCH REPORT

Application Number

EP 05 44 7246

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 519 231 A (ASML NETHERLANDS B.V) 30 March 2005 (2005-03-30) <br><br> * abstract; figures 2,3 * <br> * paragraphs [0003], [0004], [0024], [0033], [0036] * | 1-5,8, 10,11, 13-16 | INV. G03F7/20 |
| A | | 7,12 | |
| X | SEKIGUCHI ATSUSHI ET AL: "Study on the resist materials leaching from resist film during immersion exposure for 193nm using QCM method" PROCEEDINGS OF SPIE, vol. 5753, May 2005 (2005-05), pages 778-789, XP002383469 * abstract; figures 1-3,6 * * the whole document * | 1-5,8,9, 11,13-16 | |
| A | | 7,12 | |
| X | US 2005/014090 A1 (HIRAYAMA TAKU ET AL) 20 January 2005 (2005-01-20) <br><br> * abstract; figures 1-8 * <br> * paragraphs [0014], [0025] - [0031], [0047] - [0059] * | 1-5,8, 10,11, 13-16 | TECHNICAL FIELDS SEARCHED (IPC) <br><br> G03F |
| A | | 7,12 | |
| X | US 6 844 206 B1 (PHAN KHOI A ET AL) 18 January 2005 (2005-01-18) * abstract; figures 1,4 * * column 1, line 66 - column 2, line 43 * * column 5, line 1 - line 35 * | 1-5,8, 11,13-16 | |
| A | | 7,12 | |

-/--

The present search report has been drawn up for all claims

| Place of search | Date of completion of the search | Examiner |
|---|---|---|
| The Hague | 1 June 2006 | Remy, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 05 44 7246

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HINSBERG W D ET AL: "Evaluation of functional properties of imaging materials for water immersion lithography" PROCEEDINGS OF SPIE, vol. 5753, May 2005 (2005-05), pages 508-518, XP002383470 * abstract; figures 2-4 * * page 508 - page 512 * | 1-5,8, 11,13-16 | |
| A | ----- | 7,12 | |
| E | EP 1 612 604 A (ROHM AND HAAS ELECTRONIC MATERIALS, L.L.C) 4 January 2006 (2006-01-04) * abstract * * paragraphs [0004], [0016], [0100]; tables 1-3 * | 1-5,8,9, 11,13-16 | |
| | ----- | | |
| | | | TECHNICAL FIELDS SEARCHED (IPC) |

The present search report has been drawn up for all claims

| Place of search | Date of completion of the search | Examiner |
|---|---|---|
| The Hague | 1 June 2006 | Remy, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

### ANNEX TO THE EUROPEAN SEARCH REPORT
### ON EUROPEAN PATENT APPLICATION NO.

EP 05 44 7246

This annex lists the patent family members relating to the patent documents cited in the above-mentioned European search report.
The members are as contained in the European Patent Office EDP file on
The European Patent Office is in no way liable for these particulars which are merely given for the purpose of information.

01-06-2006

| Patent document cited in search report | | Publication date | Patent family member(s) | | Publication date |
|---|---|---|---|---|---|
| EP 1519231 | A | 30-03-2005 | JP | 2005175433 A | 30-06-2005 |
| | | | US | 2005094114 A1 | 05-05-2005 |
| US 2005014090 | A1 | 20-01-2005 | EP | 1589375 A1 | 26-10-2005 |
| | | | WO | 2004068242 A1 | 12-08-2004 |
| | | | JP | 2005208509 A | 04-08-2005 |
| US 6844206 | B1 | 18-01-2005 | US | 6999254 B1 | 14-02-2006 |
| | | | WO | 2005019935 A2 | 03-03-2005 |
| EP 1612604 | A | 04-01-2006 | CN | 1737685 A | 22-02-2006 |
| | | | JP | 2006072326 A | 16-03-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Advances in Resist Technology and Processing XXII. Proceedings of SPIE 5753. SPIE, 2005
- **DAMMEL.** *J. Photopolym. Sci. Technol.,* 2004, vol. 17, 591-594

- **R.R. DAMMEL et al.** *SPIE Proceedings,* 2005, vol. 7573, 95-101